# EUROPEAN PATENT APPLICATION

(11) **EP 4 664 756 A1**
(43) Date of publication of application: **17.12.2025**
(21) Application number: 24762931.4
(22) Date of filing: 26.01.2024
(51) Int. Cl.: H03F 1/26

(54) **LOW-NOISE AMPLIFIER CIRCUIT, RECEIVER, AND WIRELESS DEVICE**

(30) Priority: 01.03.2023 CN 202310242844
(71) Applicant: Huawei Technologies Co., Ltd., Shenzhen, Guangdong 518129 (CN)
(72) Inventor: SONG, Haixin, Shenzhen, Guangdong 518129 (CN)
(74) Representative: Isarpatent
(86) International application number: PCT/CN2024/074273
(87) International publication number: WO 2024/179248

(57) **Abstract**

A low noise amplifier circuit (40), a receiver (110), and a wireless device (100) are provided, and relate to the field of radio frequency integrated circuit technologies. The low noise amplifier circuit (40) includes: An input of a first-stage amplifier circuit (41) receives an operating signal, an output of the first-stage amplifier circuit is separately connected to an input of a second-stage amplifier circuit (42) and a first end of a notch circuit (43), and an output of the second-stage amplifier circuit (42) is connected to a second end of the notch circuit (43). The operating signal includes a radio frequency signal with a first frequency and an interference signal with a second frequency, the first frequency is in a preset operating frequency band, and the second frequency is in an operating frequency band other than the preset operating frequency band. An equivalent impedance value of the notch circuit (43) in the preset operating frequency band is a first impedance value, an equivalent impedance value of the notch circuit (43) in the operating frequency band other than the preset operating frequency band is a second impedance value, the first impedance value is greater than a first threshold, and the second impedance value is less than the first threshold. In this way, the low noise amplifier circuit (40) has low power consumption, a high gain, and a strong anti-interference capability.

## Description

This application claims priority to Chinese Patent Application No. 202310242844.6, filed with the China National Intellectual Property Administration on March 1, 2023 and entitled "LOW NOISE AMPLIFIER CIRCUIT, RECEIVER, AND WIRELESS DEVICE", which is incorporated herein by reference in its entirety.

### TECHNICAL FIELD

This application relates to the field of radio frequency integrated circuit technologies, and in particular, to a low noise amplifier circuit, a receiver, and a wireless device.

### BACKGROUND

A low noise amplifier circuit (low noise amplifier, LNA) can be included in a receiver of a wireless device, and the low noise amplifier circuit, as a module in the receiver, can amplify a radio frequency signal received by an antenna of the receiver into a signal with a strong anti-noise capability for use by a subsequent-stage circuit. The antenna of the receiver receives an interference signal while receiving the radio frequency signal. The interference signal affects normal operation of the receiver.

### SUMMARY

Embodiments of this application provide a low noise amplifier circuit, a receiver, and a wireless device, to reduce impact of an interference signal on the receiver.

To achieve the foregoing objective, embodiments of this application provide the following technical solutions.

According to a first aspect, a low noise amplifier circuit is provided. The low noise amplifier circuit includes a first-stage amplifier circuit, a second-stage amplifier circuit, and a notch circuit. An input of the first-stage amplifier circuit is configured to receive an operating signal, and an output of the first-stage amplifier circuit is separately connected to an input of the second-stage amplifier circuit and a first end of the notch circuit. The operating signal includes a radio frequency signal with a first frequency and an interference signal with a second frequency, the first frequency is in a preset operating frequency band, and the second frequency is in an operating frequency band other than the preset operating frequency band. An output of the second-stage amplifier circuit is connected to a second end of the notch circuit. An impedance value between the first end of the notch circuit and the second end of the notch circuit in the preset operating frequency band is a first impedance value, an impedance value between the first end of the notch circuit and the second end of the notch circuit in the operating frequency band other than the preset operating frequency band is a second impedance value, the first impedance value is greater than a first threshold, and the second impedance value is less than the first threshold.

The low noise amplifier circuit provided in this implementation includes the first-stage amplifier circuit, the second-stage amplifier circuit, and the notch circuit. The first-stage amplifier circuit receives an operating signal from an antenna of a receiver, and performs a first amplification on the operating signal. An operating signal obtained through the first amplification includes a radio frequency signal obtained through the first amplification and an interference signal obtained through the first amplification. Because the radio frequency signal obtained through the first amplification is in the preset operating frequency band, the second-stage amplifier circuit performs a second amplification on the radio frequency signal obtained through the first amplification. Because the interference signal obtained through the first amplification is in the operating frequency band other than the preset operating frequency band, the notch circuit modulates the interference signal obtained through the first amplification, to reduce interference. This improves an anti-interference capability of the low noise amplifier circuit.

With reference to a first implementation of the first aspect, the notch circuit includes a first capacitor and a first inductor, a first end of the first capacitor is connected to the second end of the notch circuit, a second end of the first capacitor is connected to a first end of the first inductor, and a second end of the first inductor is connected to the first end of the notch circuit.

In this implementation, the notch circuit is an LC resonant circuit formed by the first capacitor and the first inductor. The first capacitor and the first inductor can modulate the interference signal obtained through the first amplification, to reduce impact of the interference signal on the low noise amplifier circuit and a subsequent-stage circuit of the low noise amplifier circuit. This improves the anti-interference capability of the low noise amplifier circuit.

With reference to a second implementation of the first aspect, an oscillation frequency of the notch circuit is in the operating frequency band other than the preset operating frequency band.

In this implementation, the first capacitor and the first inductor jointly form the LC resonant circuit. A capacitance value of the first capacitor and an inductance value of the first inductor are properly set, so that the oscillation frequency of the LC resonant circuit is in the operating frequency band other than the preset operating frequency band. This can avoid amplification of the interference signal in the operating frequency band other than the preset operating frequency band, and improves the anti-interference capability of the low noise amplifier circuit.

With reference to a third implementation of the first aspect, the first capacitor is a tunable capacitor, and the first inductor is a tunable inductor.

In this implementation, the first capacitor is set as a tunable capacitor, and the first inductor is set as a tunable inductor. The oscillation frequency of the LC resonant circuit is made to be any frequency in the operating frequency band other than the preset operating frequency band by adjusting the capacitance value of the first capacitor and the inductance value of the first inductor, to suppress interference of an interference signal.

With reference to a fourth implementation of the first aspect, the first-stage amplifier circuit includes a second inductor, a third inductor, a second capacitor, a first resistor, and a first amplifier. A first end of the second inductor is connected to the input of the first-stage amplifier circuit, and a second end of the second inductor is connected to a first end of the second capacitor. A first end of the first resistor receives a first turn-on voltage, and a second end of the first resistor is connected to a second end of the second capacitor. A control end of the first amplifier is connected to the second end of the second capacitor, a first end of the first amplifier is connected to the output of the first-stage amplifier circuit, and a second end of the first amplifier is connected to a first end of the third inductor. A second end of the third inductor is grounded.

In this implementation, the second inductor and the second capacitor that are connected in series are disposed between the control end of the first amplifier and the input of the first-stage amplifier circuit. The second capacitor has a direct current blocking function. The second inductor provides an additional degree of freedom for resonance of the input of the first-stage amplifier circuit, allowing for adjustment of an operating frequency of the first-stage amplifier circuit and making input impedance have a purely resistive characteristic. The control end of the first amplifier is connected to the first resistor, and the first resistor may provide a first bias voltage for the control end of the first amplifier, so that the first amplifier is in an on state and can perform a first amplification on an operating signal. The second end of the first amplifier is grounded through the third inductor, the third inductor is a feedback inductor for the second end of the first amplifier, and the third inductor and a parasitic capacitor at the control end of the first amplifier form an input resonance network, so that real impedance is obtained to implement input impedance matching and therefore make the low noise amplifier circuit have a low noise figure.

With reference to a fifth implementation of the first aspect, the second-stage amplifier circuit includes a second resistor, a third capacitor, a fourth capacitor, a fourth inductor, and a second amplifier. A first end of the second resistor receives a second turn-on voltage, and a second end of the second resistor is connected to a control end of the second amplifier. The control end of the second amplifier is connected to a first end of the third capacitor, a first end of the second amplifier is connected to the output of the second-stage amplifier circuit, and a second end of the second amplifier is separately connected to a first end of the fourth capacitor and a first end of the fourth inductor. A second end of the fourth capacitor is grounded. A second end of the fourth inductor is separately connected to a second end of the third capacitor and the input of the second-stage amplifier circuit.

In this implementation, the second resistor provides a second bias voltage for the second amplifier based on the second turn-on voltage, so that the second amplifier is in an on state and can perform a second amplification on a radio frequency signal. The third capacitor provides coupling capacitance between the control end of the second amplifier and the first end of the first amplifier, the fourth capacitor enables an alternating-current small signal in the second amplifier to be grounded, and the fourth inductor provides a direct-current path between the second amplifier and the first amplifier, so that a bias current is shared in the low noise amplifier circuit, to achieve a high gain and good noise performance with low power consumption.

With reference to a sixth implementation of the first aspect, the low noise amplifier circuit further includes a load circuit, and an input of the load circuit is connected to the output of the second-stage amplifier circuit.

In this implementation, the load circuit is configured at the output of the second-stage amplifier circuit, a radio frequency signal obtained through two amplifications is provided to the load circuit, and the load circuit converts the radio frequency signal obtained through the two amplifications from a single-ended signal into a differential signal for output, to facilitate processing by a subsequent-stage circuit of the low noise amplifier circuit.

With reference to a seventh implementation of the first aspect, the load circuit includes a first gating switch, a first switch, a second switch, a fifth capacitor, and a transformer. A common end of the first gating switch receives a third turn-on voltage, a first gating end of the first gating switch is connected to a control end of the first switch, and a second gating end of the first gating switch is connected to a control end of the second switch. A first end of the first switch is connected to a first power supply, and a second end of the first switch is connected to a first end of the load circuit. A first end of the second switch is connected to a second end of the fifth capacitor, and a second end of the second switch is connected to the first end of the load circuit. A first end of the fifth capacitor is separately connected to the first power supply and a first end of a primary coil of the transformer, and the second end of the fifth capacitor is connected to a second end of the primary coil of the transformer.

In this implementation, the first gating switch is used to control the first switch or the second switch to be turned on, so that a gain of the low noise amplifier circuit can be adjusted according to a requirement. Specifically, when the first switch is controlled to be turned on, the gain of the low noise amplifier circuit is low; or when the second switch is controlled to be turned on, the gain of the low noise amplifier circuit is high. In addition, the fifth capacitor and the transformer convert a radio frequency signal that is obtained through two amplifications and that is output by the second-stage amplifier circuit from a single-ended signal into a differential signal for output, to facilitate processing by a subsequent-stage circuit of the low noise amplifier circuit.

With reference to an eighth implementation of the first aspect, oscillation frequencies of the fifth capacitor and the primary coil of the transformer are in the preset operating frequency band.

In this implementation, the fifth capacitor and the primary coil of the transformer jointly form an LC resonant circuit. A capacitance value of the fifth capacitor is properly set, so that an oscillation frequency of the LC resonant circuit is in the preset operating frequency band. In this way, the gain of the low noise amplifier circuit can be further increased.

With reference to a ninth implementation of the first aspect, the fifth capacitor is a tunable capacitor.

In this implementation, the fifth capacitor is set as a tunable capacitor, and the oscillation frequency of the LC resonant circuit is made to be any frequency in the preset operating frequency band by adjusting the capacitance value of the fifth capacitor, to increase the gain of the low noise amplifier circuit.

With reference to a tenth implementation of the first aspect, the first gating switch includes a control end; and the control end of the first gating switch receives a first control word, and the first control word is used to control the common end of the first gating switch to connect to the first gating end of the first gating switch; or the control end of the first gating switch receives a second control word, and the second control word is used to control the common end of the first gating switch to connect to the second gating end of the first gating switch.

In this implementation, the control end of the first gating switch receives the first control word, and the common end of the first gating switch is connected to the first gating end of the first gating switch under the control of the first control word, so that a part of an output current of the second-stage amplifier circuit flows into the first switch. Alternatively, the control end of the first gating switch receives the second control word, and the common end of the first gating switch is connected to the second gating end of the first gating switch under the control of the second control word, so that a part of an output current of the second-stage amplifier circuit flows into the second switch. In addition, the first gating switch may further adjust, under the control of the first control word or the second control word, a proportion of an output current of the second-stage amplifier circuit flowing into the first switch or the second switch, to adjust the gain of the low noise amplifier circuit.

According to a second aspect, a receiver is provided. The receiver includes an antenna and a low noise amplifier circuit. The low noise amplifier circuit is configured to amplify a radio frequency signal received by the antenna.

According to a third aspect, a wireless device is provided. The wireless device includes a receiver and a data processor. The data processor is configured to process a radio frequency signal output by the receiver.

For technical effects achieved by any one of the possible implementations of the second aspect and the third aspect, refer to technical effects achieved by different implementations of the first aspect. Details are not described herein again.

### BRIEF DESCRIPTION OF DRAWINGS

To describe technical solutions in embodiments of the present invention more clearly, the following briefly describes accompanying drawings for describing embodiments. It is clear that the accompanying drawings in the following descriptions show merely some embodiments of the present invention, and a person of ordinary skill in the art may derive other drawings from these accompanying drawings without creative efforts.
FIG. 1 is a diagram of an operating frequency band of a receiver according to an embodiment of this application;
FIG. 2 is a schematic of a low noise amplifier circuit according to an embodiment of this application;
FIG. 3 is a diagram of operation of a low noise amplifier circuit according to an embodiment of this application;
FIG. 4 is a schematic of a low noise amplifier circuit according to an embodiment of this application;
FIG. 5 is a diagram of operation of a low noise amplifier circuit according to an embodiment of this application;
FIG. 6 is a schematic of a low noise amplifier circuit according to an embodiment of this application;
FIG. 7 is a schematic of a low noise amplifier circuit according to an embodiment of this application;
FIG. 8 is a schematic of a low noise amplifier circuit according to an embodiment of this application;
FIG. 9 is a schematic of a low noise amplifier circuit according to an embodiment of this application;
FIG. 10 is a schematic of a low noise amplifier circuit according to an embodiment of this application;
FIG. 11 is a schematic of a low noise amplifier circuit according to an embodiment of this application;
FIG. 12 is a diagram of operation of a low noise amplifier circuit according to an embodiment of this application;
FIG. 13 is a diagram of communication between a wireless device and a wireless communication system according to an embodiment of this application; and
FIG. 14 is a diagram of communication between a wireless device and a wireless communication system according to an embodiment of this application.

### DESCRIPTION OF EMBODIMENTS

The following describes technical solutions in embodiments of this application with reference to accompanying drawings in embodiments of this application. It is clear that the described embodiments are merely a part rather than all of embodiments of this application.

The terms "first", "second", and the like mentioned below are merely intended for a purpose of description, and shall not be understood as an indication or implication of relative importance or implicit indication of a quantity of indicated technical features. Therefore, a feature defined by "first", "second", or the like may explicitly or implicitly include one or more features.

It should be noted that a "connection" in embodiments of this application may be understood as an electrical connection, and a connection between two electrical elements may be a direct connection or an indirect connection between the two electrical elements. For example, that A is connected to B may be that A is directly connected to B, or may be that A is indirectly connected to B through one or more other electrical elements. For example, that A is connected to B may alternatively be that A is directly connected to C, C is directly connected to B, A and B are connected through C. In some scenarios, the "connection" may also be understood as coupling, for example, electromagnetic coupling between two inductors. In conclusion, the connection between A and B enables transmission of electric energy between A and B.

It should be noted that an amplifier and a switch in embodiments of this application may be transistors, for example, one or more of a plurality of types of transistors such as a metal oxide semiconductor field effect transistor (metal oxide semiconductor field effect transistor, MOSFET), a bipolar junction transistor (bipolar junction transistor, BJT), and an insulated gate bipolar transistor (insulated gate bipolar transistor, IGBT). Examples are not enumerated in embodiments of this application. Each transistor may include a control end, a first end, and a second end. The control end is configured to control a status of the transistor. For example, when the transistor is used as a switch, the control end is configured to control conduction or cut-off of the transistor. When the transistor is conducted, a current can be transmitted between the first end and the second end of the transistor. When the transistor is cut off, a current cannot be transmitted between the first end and the second end of the transistor. The MOSFET is used as an example. The control end of the transistor is a gate, and the first end of the transistor may be a source of the transistor and the second end may be a drain of the transistor; or the first end may be a drain of the transistor and the second end may be a source of the transistor. Certainly, when the transistor is used as a switch, the transistor may also be replaced with a relay. When the transistor is used as an amplifier, the control end is configured to control a current amplification multiple if the transistor operates in a current amplification state. When the transistor is in an operating state, if a current between the control end and the second end of the transistor is changed, a current between the first end and the second end of the transistor is also changed, and a variation of the current between the first end and the second end of the transistor and a variation of the current between the control end and the second end of the transistor satisfy a specific proportional relationship. For example, when the variation of the current between the control end and the second end of the transistor is ΔIb, the variation of the current between the first end and the second end of the transistor is ΔIc=β×ΔIb, where β is an amplification multiple and is generally far greater than 1, for example, in a range of dozens or hundreds. When the transistor is in an off state, a current cannot be transmitted between the first end and the second end of the transistor. In some optional embodiments, the transistor may further include a third end, and the third end of the transistor is connected to a substrate of the transistor. The MOSFET is used as an example. The control end of the transistor is a base, the first end of the transistor may be an emitter of the transistor, the second end may be a collector of the transistor, and the third end may be a substrate of the transistor.

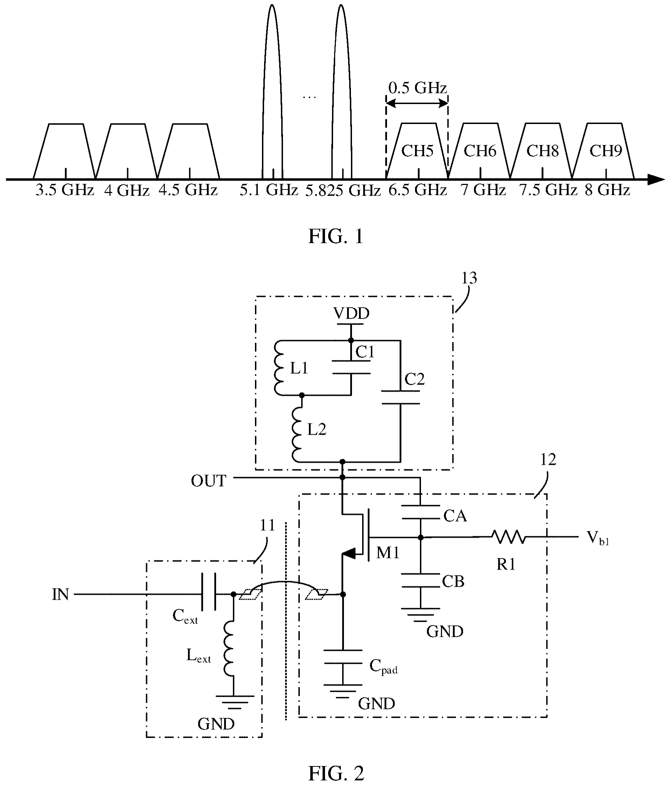

An antenna of a receiver may receive signals with different frequency bands according to a type of the receiver. For example, as shown in FIG. 1, the receiver is an ultra-wideband UWB (ultra-wideband, UWB) receiver, and an antenna of the UWB receiver may receive a radio frequency signal with an operating frequency band in a low frequency band of 3.1 gigahertz (GHz) to 4.8 GHz and/or a radio frequency signal with an operating frequency band in a high frequency band of 6.0 GHz to 10.6 GHz, and may also receive an interference signal with an operating frequency band in a mid-frequency band of 4.8 GHz to 6.0 GHz. However, compared with a radio frequency signal, an interference signal such as 802.11a/b/g/n has higher signal strength, and excessive interference signals are likely to affect the receiver. To reduce impact of an interference signal, the receiver usually operates on a high frequency band, for example, on a channel 5 (CH5) to a channel 9 (CH9) whose center frequencies are in 6.5 GHz to 8 GHz, to reduce impact of the interference signal. However, some interference signals, for example, 802.11a signals with a maximum frequency reaching 5.825 GHz, still affect the receiver to some extent. To ensure performance of the receiver, a low noise amplifier circuit is required to provide a strong interference signal suppression capability, to prevent an interference signal from being excessively large and distorting a radio frequency signal and saturating a subsequent-stage circuit such as a frequency mixer. It may be understood that the low frequency band, the mid-frequency band, and the high frequency band mean three groups of frequency bands (or frequency band groups), and each frequency band group includes several frequency bands (or briefly referred to as "bands").

To resolve the foregoing problem, an embodiment of this application provides a low noise amplifier circuit. With reference to FIG. 2, the low noise amplifier circuit includes an impedance matching circuit 11, a first-stage amplifier circuit 12, and a load circuit 13. An input IN of the impedance matching circuit 11 is connected to an antenna of a receiver, an output of the impedance matching circuit 11 is connected to an input of the first-stage amplifier circuit 12, and an output OUT of the first-stage amplifier circuit 12 is connected to an input of the load circuit 13. It may be understood that, in this embodiment, the impedance matching circuit 11 is located outside a chip, and the impedance matching circuit 11 may be connected to the first-stage amplifier circuit 12 and the load circuit 13 by using a bonding (bonding, or bonding) line. The whole or a part of the first-stage amplifier circuit 12 and the whole or a part of the load circuit 13 may be implemented on one or more chips. The chips may be an analog integrated circuit (integrated circuit, IC), a radio frequency integrated circuit (radio frequency integrated circuit, RFIC), a signal IC, and the like.

The impedance matching circuit 11 includes a first inductor Lₑₓₜ and a first capacitor Cₑₓₜ. A first end of the first capacitor Cₑₓₜ receives an operating signal, a second end of the first capacitor Cₑₓₜ is separately connected to a first end of the first inductor Lₑₓₜ and an input IN of the first-stage amplifier circuit 12, and a second end of the first inductor Lₑₓₜ is grounded GND. The operating signal includes a radio frequency signal with a first frequency and an interference signal with a second frequency. Generally, when the low noise amplifier circuit is used in a UWB receiver, the first frequency may be any frequency in a low frequency band of 3.1 GHz to 4.8 GHz or in a high frequency band of 6.0 GHz to 10.6 GHz, and the second frequency may be any frequency in a mid-frequency band of 4.8 GHz to 6.0 GHz.

The first-stage amplifier circuit 12 includes a first amplifier M1, a second capacitor CA, a third capacitor CB, a fourth capacitor C_{pad}, and a first resistor R1. A first end of the first resistor R1 receives a first turn-on voltage V_{b1}, a second end of the first resistor R1 is connected to a control end of the first amplifier M1, a first end of the first amplifier M1 is connected to the output OUT of the first-stage amplifier circuit 12, and a second end of the first amplifier M1 is grounded GND through the fourth capacitor C_{pad}. A first end of the second capacitor CA is connected to the output OUT of the first-stage amplifier circuit 12, and a second end of the second capacitor CA is connected to the second end of the first resistor R1. A first end of the third capacitor CB is connected to the second end of the first resistor R1, and a second end of the third capacitor CB is grounded GND.

The load circuit 13 includes a second inductor L1, a third inductor L2, a fifth capacitor C1, and a sixth capacitor C2. A first end of the second inductor L1 is connected to a first power supply VDD, a second end of the second inductor L1 is connected to a first end of the third inductor L2, and a second end of the third inductor L2 is connected to the input of the load circuit 13. A first end of the fifth capacitor C1 is connected to the first power supply VDD, and a second end of the fifth capacitor C1 is connected to the second end of the second inductor L1. A first end of the sixth capacitor C2 is connected to the first power supply VDD, and a second end of the sixth capacitor C2 is connected to the input of the load circuit 13.

In this embodiment, the impedance matching circuit 11 including the first inductor Lₑₓₜ and the first capacitor Cₑₓₜ is used to implement input impedance matching. In addition, the impedance matching circuit 11 receives an operating signal from the antenna of the receiver, and transmits the operating signal to the first-stage amplifier circuit 12. The first-stage amplifier circuit 12 amplifies a radio frequency signal in the operating signal, and provides an amplified radio frequency signal to the load circuit 13. Because the second inductor L1, the third inductor L2, the fifth capacitor C1, and the sixth capacitor C2 in the load circuit 13 form an LC resonant circuit, when inductance values of the second inductor L1 and the third inductor L2 and capacitance values of the fifth capacitor C1 and the sixth capacitor C2 are properly set, the load circuit 13 can provide a low-impedance path for an interference signal with an operating frequency band in the mid-frequency band of 4.8 GHz to 6.0 GHz. In this case, the interference signal flows into the load circuit. In addition, the load circuit 13 can further provide a high-impedance path for a radio frequency signal with an operating frequency band in the low frequency band of 3.1 GHz to 4.8 GHz and/or a radio frequency signal with an operating frequency band in the high frequency band of 6.0 GHz to 10.6 GHz. In this case, the radio frequency signal can be output through the output OUT of the first-stage amplifier circuit 12. In this way, the load circuit can also be used as a notch circuit to filter out the interference signal.

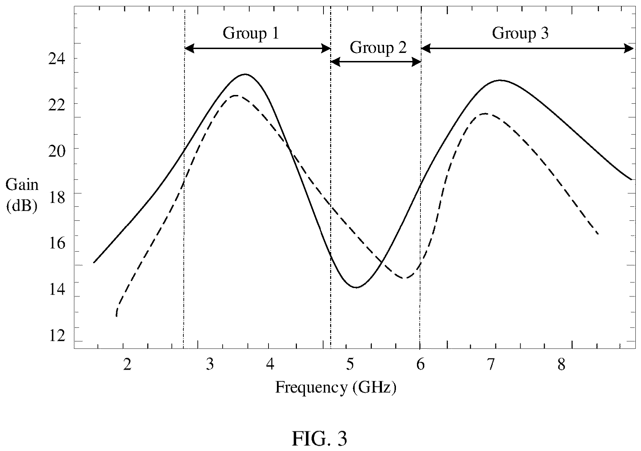

FIG. 3 shows operation of the low noise amplifier circuit used in a UWB receiver. A solid line in FIG. 3 shows simulated operation of the low noise amplifier circuit, and a dashed line in FIG. 3 shows actual operation of the low noise amplifier circuit. It can be learned from the operation of the low noise amplifier circuit that, for a radio frequency signal with an operating frequency band in the low frequency band (Group 1) of 3.1 GHz to 4.8 GHz and/or a radio frequency signal with an operating frequency band in the high frequency band (Group 3) of 6.0 GHz to 10.6 GHz, the low noise amplifier circuit can provide a maximum gain of 24 dB; and for an interference signal with an operating frequency band in the mid-frequency band (Group 2) of 4.8 GHz to 6.0 GHz, the low noise amplifier circuit can provide a gain of approximately 14 dB or more. Overall, the low noise amplifier circuit can provide maximum suppression of approximately 10 dB for the interference signal. It can be learned that the low noise amplifier circuit in this embodiment of this application can suppress the interference signal to some extent. However, due to a limitation of a system on chip, quality factors Q of a plurality of inductors cannot be excessively large. As a result, the low noise amplifier circuit cannot have a stronger interference suppression capability.

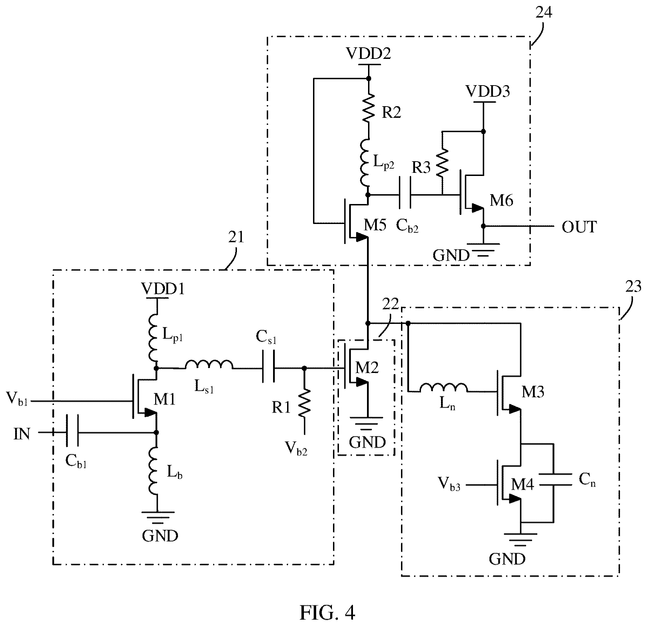

To improve an anti-interference capability of a low noise amplifier circuit, as shown in FIG. 4, an embodiment of this application further provides a low noise amplifier circuit. The low noise amplifier circuit includes a first-stage amplifier circuit 21, a second-stage amplifier circuit 22, an active notch circuit 23, and a load circuit 24. An input of the first-stage amplifier circuit 21 receives an operating signal from an antenna, an output of the first-stage amplifier circuit 21 is connected to an input of the second-stage amplifier circuit 22, and an output of the second-stage amplifier circuit 22 is separately connected to an input of the active notch circuit 23 and an input of the load circuit 24.

The first-stage amplifier circuit 21 includes a first amplifier M1, a first capacitor C_{b1}, a second capacitor Cₛ₁, a first inductor Lₚ₁, a second inductor L_{b}, a third inductor Lₛ₁, and a first resistor R1. A first end of the first capacitor C_{b1} is connected to the input IN of the first-stage amplifier circuit 21, and a second end of the first capacitor C_{b1} is connected to a second end of the first amplifier M1. A control end of the first amplifier M1 receives a first turn-on voltage V_{b1}, a first end of the first amplifier M1 is connected to a first power supply VDD1 through the first inductor Lₚ₁, and the second end of the first amplifier M1 is grounded GND through the second inductor L_{b}. A first end of the third inductor Lₛ₁ is connected to the first end of the first amplifier M1, a second end of the third inductor Lₛ₁ is connected to a first end of the second capacitor Cₛ₁, and a second end of the second capacitor Cₛ₁ is connected to the output of the first-stage amplifier circuit 21. A first end of the first resistor R1 receives a second turn-on voltage V_{b2}, and a second end of the first resistor R1 is connected to the output of the first-stage amplifier circuit 21.

The second-stage amplifier circuit 22 includes a second amplifier M2. A control end of the second amplifier M2 is connected to the input of the second-stage amplifier circuit 22, a first end of the second amplifier M2 is connected to the output of the second-stage amplifier circuit 22, and a second end of the second amplifier M2 is grounded GND.

The active notch circuit 23 includes a first switch M3, a second switch M4, a fourth inductor Lₙ, and a third capacitor Cₙ. A control end of the first switch M3 is connected to the input of the active notch circuit 23 through the fourth inductor Ln, a first end of the first switch M3 is connected to the input of the active notch circuit 23, and a second end of the first switch M3 is connected to a first end of the second switch M4. A control end of the second switch M4 receives a third turn-on voltage V_{b3}, the first end of the second switch M4 is connected to a first end of the third capacitor Cn, and a second end of the second switch M4 is grounded GND. A second end of the third capacitor Cn is connected to the second end of the second switch M4.

The load circuit 24 includes a third switch M5, a fourth switch M6, a fifth inductor Lₚ₂, a fourth capacitor C_{b2}, a second resistor R2, and a third resistor R3. A control end of the third switch M5 is connected to a second power supply VDD2, a first end of the third switch M5 is separately connected to a first end of the fifth inductor Lₚ₂ and a first end of the fourth capacitor C_{b2}, and a second end of the third switch M5 is connected to the input of the load circuit 24. A first end of the second resistor R2 is connected to the second power supply VDD2, and a second end of the second resistor R2 is connected to a second end of the fifth inductor Lₚ₂. A control end of the fourth switch M6 is connected to a second end of the fourth capacitor C_{b2}, a first end of the fourth switch M6 is connected to a third power supply VDD3, and a second end of the fourth switch M6 is grounded GND. A first end of the third resistor R3 is connected to the third power supply VDD3, and a second end of the third resistor R3 is connected to the control end of the fourth switch M6.

In this embodiment, the first-stage amplifier circuit 21 receives an operating signal from an antenna of a receiver, and performs a first amplification on the operating signal; and the second-stage amplifier circuit 22 performs a second amplification on an operating signal obtained through the first amplification, and provides an operating signal obtained through the second amplification to the active notch circuit 23 and the load circuit 24. The operating signal obtained through the second amplification includes a radio frequency signal obtained through the two amplifications and an interference signal obtained through the two amplifications. An oscillation frequency of the active notch circuit 23 is in an operating frequency band of the interference signal. For example, the oscillation frequency of the active notch circuit is any frequency in a mid-frequency band of 4.8 GHz to 6.0 GHz. In this case, the active notch circuit 23 provides a high-impedance path for the radio frequency signal obtained through the two amplifications, and the radio frequency signal obtained through the two amplifications may be output after passing through the load circuit 24. In addition, the active notch circuit 23 further provides a low-impedance path for the interference signal obtained through the two amplifications, and the interference signal obtained through the two amplifications may be grounded after passing through the active notch circuit 23. In this way, the active notch circuit implements a function of suppressing the interference signal.

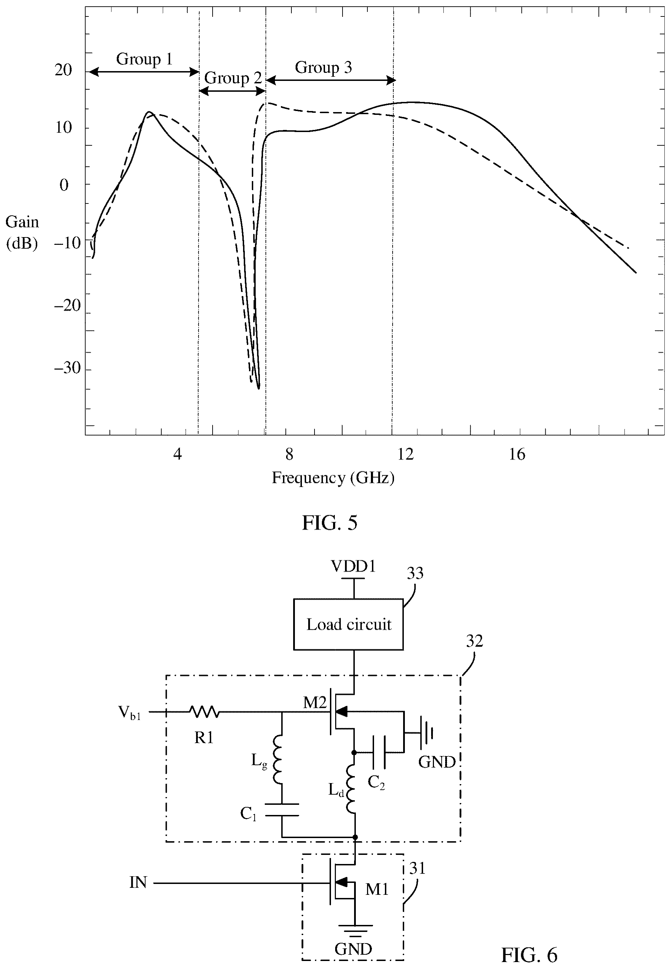

FIG. 5 shows operation of the low noise amplifier circuit used in a UWB receiver. A solid line in FIG. 5 shows simulated operation of the low noise amplifier circuit, and a dashed line in FIG. 5 shows actual operation of the low noise amplifier circuit. It can be learned from the operation of the low noise amplifier circuit that, for a radio frequency signal with an operating frequency band in a low frequency band (Group 1) of 3.1 GHz to 4.8 GHz and/or a radio frequency signal with an operating frequency band in a high frequency band (Group 3) of 6.0 GHz to 10.6 GHz, the low noise amplifier circuit can provide a maximum gain of 15 dB; and for an interference signal with an operating frequency band in the mid-frequency band (Group 2) of 4.8 GHz to 6.0 GHz, the low noise amplifier circuit can provide a gain of approximately -30 dB or more. Overall, the low noise amplifier circuit can provide maximum suppression of 45 dB for the interference signal. It can be learned that, in this embodiment, because the active notch circuit has a high quality factor, the low noise amplifier circuit has a strong interference suppression capability. However, the active notch circuit needs an additional circuit area and causes additional power consumption, and increases a noise figure of the low noise amplifier circuit.

To reduce a noise figure of a low noise amplifier circuit, an embodiment of this application further provides a low noise amplifier circuit. With reference to FIG. 6, the low noise amplifier circuit includes a first-stage amplifier circuit 31, a second-stage amplifier circuit 32, and a load circuit 33. An input of the first-stage amplifier circuit 31 receives an operating signal, an output of the first-stage amplifier circuit 31 is connected to an input of the second-stage amplifier circuit 32, an output of the second-stage amplifier circuit 32 is connected to a first end of the load circuit 33, and a second end of the load circuit 33 is connected to a first voltage VDD1.

The first-stage amplifier circuit 31 includes a first amplifier M1. A control end of the first amplifier M1 is connected to the input IN of the first-stage amplifier circuit 31, a first end of the first amplifier M1 is connected to the output of the first-stage amplifier circuit 31, and a second end of the first amplifier M1 and a third end of the first amplifier M1 are grounded GND.

The second-stage amplifier circuit 32 includes a second amplifier M2, a first capacitor C₁, a second capacitor C₂, a first inductor L_{g}, a second inductor L_{d}, and a first resistor R1. A first end of the first resistor R1 receives a first turn-on voltage V_{b1}, and a second end of the first resistor R1 is connected to a control end of the second amplifier M2. The control end of the second amplifier M2 is connected to a first end of the first inductor L_{g}, a first end of the second amplifier M2 is connected to the output of the second-stage amplifier circuit 32, a second end of the second amplifier M2 is separately connected to a first end of the second inductor L_{d} and a first end of the second capacitor C₂, and a third end of the second amplifier M2 is connected to a second end of the second capacitor C₂ and is grounded GND. A second end of the second inductor L_{d} is connected to the input of the second-stage amplifier circuit 32. A second end of the first inductor L_{g} is connected to a first end of the first capacitor C₁. A second end of the first capacitor C₁ is connected to the input of the second-stage amplifier circuit 32.

In this embodiment, the first-stage amplifier circuit 31 receives an operating signal from an antenna of a receiver, and performs a first amplification on the operating signal; and the second-stage amplifier circuit 32 performs a second amplification on an operating signal obtained through the first amplification, and provides an operating signal obtained through the second amplification to the load circuit 33. Because a bias current in the first-stage amplifier circuit 31 is provided to the load circuit 33 after passing through the second-stage amplifier circuit 32, the same bias current is shared in the low noise amplifier circuit, so that gains of circuits in the low noise amplifier circuit are superimposed. This improves utilization of a current in the low noise amplifier circuit, and can achieve a high gain and good noise performance with low power consumption. However, compared with the low noise amplifier circuits shown in FIG. 2 and FIG. 4, the low noise amplifier circuit in this embodiment has a poor anti-interference capability because the low noise amplifier circuit does not have a notch circuit to filter out an interference signal.

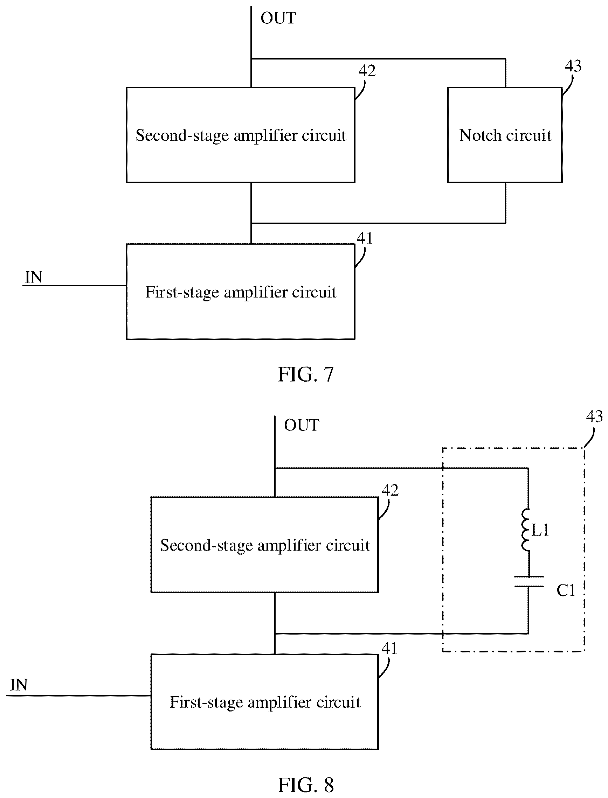

To resolve the foregoing problem, an embodiment of this application further provides a low noise amplifier circuit. With reference to FIG. 7, the low noise amplifier circuit includes a first-stage amplifier circuit 41, a second-stage amplifier circuit 42, and a notch circuit 43. An input IN of the first-stage amplifier circuit 41 is configured to receive an operating signal, and an output of the first-stage amplifier circuit 41 is separately connected to an input of the second-stage amplifier circuit 42 and a first end of the notch circuit 43. The operating signal includes a radio frequency signal with a first frequency and an interference signal with a second frequency, the first frequency is in a preset operating frequency band, and the second frequency is in an operating frequency band other than the preset operating frequency band. An output OUT of the second-stage amplifier circuit 42 is connected to a second end of the notch circuit 43.

In this embodiment, an impedance value between the first end of the notch circuit 43 and the second end of the notch circuit 43 in the preset operating frequency band is a first impedance value. In other words, an equivalent impedance value of the notch circuit 43 in the preset operating frequency band is the first impedance value. The first impedance value is greater than a first threshold. An impedance value between the first end of the notch circuit 43 and the second end 43 of the notch circuit in the operating frequency band other than the preset operating frequency band is a second impedance value. In other words, an equivalent impedance value of the notch circuit in the operating frequency band other than the preset operating frequency band is the second impedance value. The second impedance value is less than the first threshold. For example, the first threshold may be far greater than an equivalent impedance value of the second-stage amplifier circuit 42. In this case, the notch circuit 43 can provide a low-impedance path between the first-stage amplifier circuit 41 and the second-stage amplifier circuit 42 for a signal in the operating frequency band other than the preset operating frequency band, for example, an interference signal, so that the second-stage amplifier circuit 42 is bypassed, and the interference signal is suppressed after passing through the notch circuit 43. In addition, the notch circuit 43 can further provide a high-impedance path between the first-stage amplifier circuit 41 and the second-stage amplifier circuit 42 for a signal in the preset operating frequency band, for example, a radio frequency signal, so that the signal in the preset operating frequency band can be amplified after passing through the second-stage amplifier circuit 42. It may be understood that, in this embodiment, the preset operating frequency band may be a low frequency band of 3.1 GHz to 4.8 GHz and/or a high frequency band of 6.0 GHz to 10.6 GHz, and the operating frequency band other than the preset operating frequency band may be a mid-frequency band of 4.8 GHz to 6.0 GHz.

A specific operating process of the low noise amplifier circuit provided in this embodiment is as follows: The first-stage amplifier circuit 41 receives an operating signal from an antenna of a receiver, and performs a first amplification on the operating signal. An operating signal obtained through the first amplification includes a radio frequency signal obtained through the first amplification and an interference signal obtained through the first amplification. Because the radio frequency signal obtained through the first amplification is in the preset operating frequency band, the second-stage amplifier circuit 42 performs a second amplification on the radio frequency signal obtained through the first amplification. Because the interference signal obtained through the first amplification is in the operating frequency band other than the preset operating frequency band, the notch circuit 43 filters out the interference signal obtained through the first amplification, to reduce interference. This improves an anti-interference capability of the low noise amplifier circuit.

In an optional embodiment, as shown in FIG. 8, the notch circuit 43 includes a first capacitor C1 and a first inductor L1. A first end of the first capacitor C1 is connected to the second end of the notch circuit 43, a second end of the first capacitor C1 is connected to a first end of the first inductor L1, and a second end of the first inductor L1 is connected to the first end of the notch circuit 43.

In this embodiment, the notch circuit is an LC resonant circuit formed by the first capacitor and the first inductor. The first capacitor C1 and the first inductor L1 can filter out the interference signal obtained through the first amplification, to reduce impact of the interference signal on the low noise amplifier circuit and a subsequent-stage circuit of the low noise amplifier circuit. This improves the anti-interference capability of the low noise amplifier circuit.

In a preferred embodiment, an oscillation frequency of the notch circuit is in the operating frequency band other than the preset operating frequency band.

In this embodiment, the first capacitor and the first inductor jointly form the LC resonant circuit. A capacitance value of the first capacitor and an inductance value of the first inductor are properly set, so that the oscillation frequency of the LC resonant circuit is in the operating frequency band other than the preset operating frequency band. This can avoid amplification of an interference signal in the operating frequency band other than the preset operating frequency band, and improves the anti-interference capability of the low noise amplifier circuit. In addition, the notch circuit is different from the active notch circuit shown in FIG. 4. The notch circuit has a simple structure and does not require an additional power supply, so that the low noise amplifier circuit can have a low noise figure.

In an optional embodiment, the first capacitor is a tunable capacitor, and the first inductor is a tunable inductor.

In this embodiment, the first capacitor is set as a tunable capacitor, and the first inductor is set as a tunable inductor. The oscillation frequency of the LC resonant circuit is made to be any frequency in the operating frequency band other than the preset operating frequency band by adjusting the capacitance value of the first capacitor and the inductance value of the first inductor, to suppress interference of an interference signal. For example, if strength of an 802.11a signal in interference signals is the greatest, the oscillation frequency of the LC resonant circuit may be made to be an operating frequency of the 802.11a signal by adjusting the capacitance value of the first capacitor and the inductance value of the first inductor. To be specific, the oscillation frequency of the LC resonant circuit is 5.825 GHz.

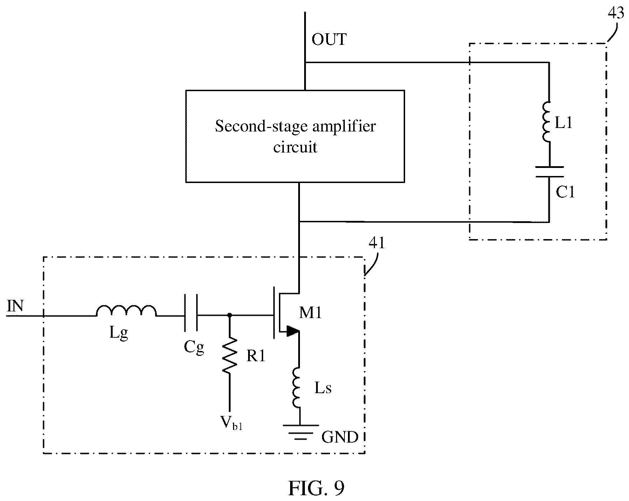

In an optional embodiment, as shown in FIG. 9, the first-stage amplifier circuit 41 includes a second inductor Lg, a third inductor Ls, a second capacitor Cg, a first resistor R1, and a first amplifier M1. A first end of the second inductor Lg is connected to the input IN of the first-stage amplifier circuit 41, and a second end of the second inductor Lg is connected to a first end of the second capacitor Cg. A first end of the first resistor R1 receives a first turn-on voltage, and a second end of the first resistor R1 is connected to a second end of the second capacitor Cg. A control end of the first amplifier M1 is connected to the second end of the second capacitor Cg, a first end of the first amplifier M1 is connected to the output of the first-stage amplifier circuit 41, and a second end of the first amplifier M1 is connected to a first end of the third inductor Ls. A second end of the third inductor Ls is grounded GND.

In this embodiment, the second inductor Lg and the second capacitor Cg that are connected in series are disposed between the control end of the first amplifier M1 and the input IN of the first-stage amplifier circuit 41. The second capacitor Cg has a direct current blocking function. The second inductor Lg provides an additional degree of freedom for resonance of the input of the first-stage amplifier circuit 41, allowing for adjustment of an operating frequency of the first-stage amplifier circuit 41 and making input impedance have a purely resistive characteristic. The control end of the first amplifier M1 is connected to the first resistor, and the first resistor R1 may provide a first bias voltage for the control end of the first amplifier M1, so that the first amplifier M1 is in an operating state and can perform a first amplification on an operating signal. The second end of the first amplifier M1 is grounded GND through the third inductor Ls, the third inductor Ls is a feedback inductor for the second end of the first amplifier, and the third inductor Ls and a parasitic capacitor at the control end of the first amplifier form an input resonance network, so that real impedance is obtained to implement input impedance matching and therefore make the low noise amplifier circuit in this embodiment of this application have a low noise figure.

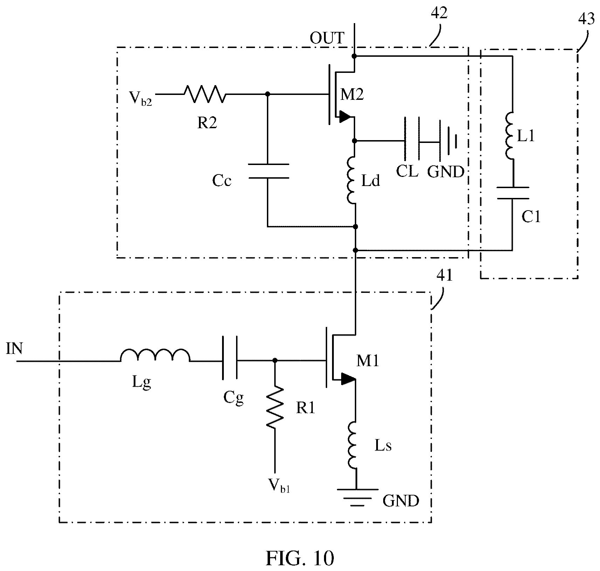

In an optional embodiment, as shown in FIG. 10, the second-stage amplifier circuit 42 includes a second resistor R2, a third capacitor Cc, a fourth capacitor CL, a fourth inductor Ld, and a second amplifier M2. A first end of the second resistor R2 receives a second turn-on voltage V_{b2}, and a second end of the second resistor R2 is connected to a control end of the second amplifier M2. The control end of the second amplifier M2 is connected to a first end of the third capacitor Cc, a first end of the second amplifier M2 is connected to the output OUT of the second-stage amplifier circuit 42, and a second end of the second amplifier M2 is separately connected to a first end of the fourth capacitor CL and a first end of the fourth inductor Ld. A second end of the fourth capacitor CL is grounded GND. A second end of the fourth inductor Ld is separately connected to a second end of the third capacitor Cc and the input of the second-stage amplifier circuit 42.

In this embodiment, the second resistor R2 provides a second bias voltage for the second amplifier M2 based on the second turn-on voltage V_{b2}, so that the second amplifier M2 is in an operating state and can perform a second amplification on a radio frequency signal. The third capacitor Cc provides coupling capacitance between the control end of the second amplifier M2 and the first end of the first amplifier M1, the fourth capacitor CL makes an alternating-current small signal in the second amplifier M2 grounded GND, and the fourth inductor Ld provides a direct-current path between the second amplifier M2 and the first amplifier M1. In this case, an output bias current of the first-stage amplifier circuit may flow into the second-stage amplifier circuit, so that the bias current is shared in the low noise amplifier circuit, and gains of circuits in the low noise amplifier circuit are superimposed. In this way, the low noise amplifier circuit can achieve a high gain and good noise performance with low power consumption.

In an optional embodiment, the low noise amplifier circuit further includes a load circuit, and an input of the load circuit is connected to the output of the second-stage amplifier circuit.

In this embodiment, the load circuit is configured at the output of the second-stage amplifier circuit, a radio frequency signal obtained through two amplifications is provided to the load circuit, and the load circuit converts the radio frequency signal obtained through the two amplifications from a single-ended signal into a differential signal for output, to facilitate processing by a subsequent-stage circuit of the low noise amplifier circuit.

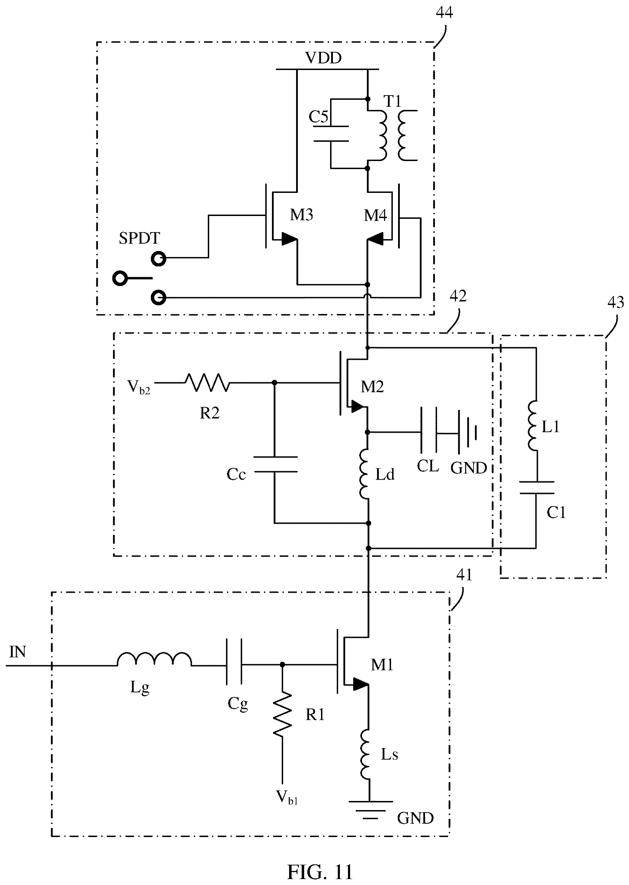

In an optional embodiment, as shown in FIG. 11, a load circuit 44 includes a first gating switch SPDT, a first switch M3, a second switch M4, a fifth capacitor C5, and a transformer T1. A common end of the first gating switch SPDT receives a third turn-on voltage, a first gating end of the first gating switch SPDT is connected to a control end of the first switch M3, and a second gating end of the first gating switch SPDT is connected to a control end of the second switch M4. A first end of the first switch M3 is connected to a first power supply VDD, and a second end of the first switch M3 is connected to a first end of the load circuit 44. A first end of the second switch M4 is connected to a second end of the fifth capacitor C5, and a second end of the second switch M4 is connected to the first end of the load circuit 44. A first end of the fifth capacitor C5 is separately connected to the first power supply VDD and a first end of a primary coil of the transformer T1, and the second end of the fifth capacitor C5 is connected to a second end of the primary coil of the transformer T1. For example, the first gating switch SPDT is a single-pole double-throw switch, and the transformer T1 may be a balun (Balun, balanced-unbalanced), namely, a balanced-unbalanced converter.

In this embodiment, the first gating switch SPDT is used to control the first switch M3 or the second switch M4 to be turned on, so that a gain of the low noise amplifier circuit can be adjusted according to a requirement. For example, when the low noise amplifier circuit is required to have a high gain, the second switch M4 is controlled to be turned on, and the fifth capacitor C5 and the transformer T1 convert a radio frequency signal that is obtained through two amplifications and that is output by the second-stage amplifier circuit 42 from a single-ended signal into a differential signal for output, to facilitate processing by a subsequent-stage circuit of the low noise amplifier circuit.

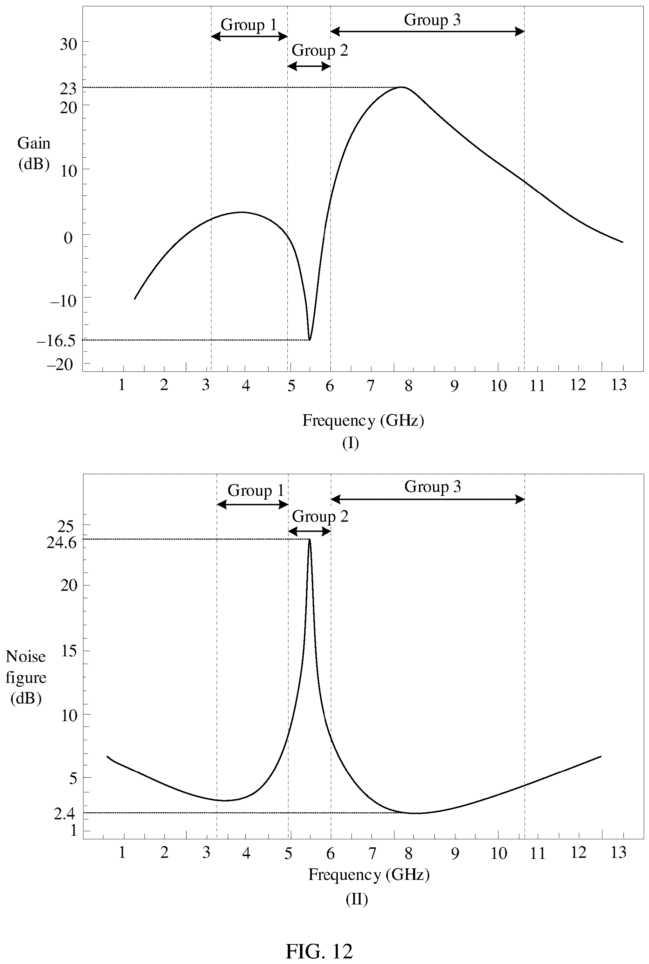

The following uses an example in which the low noise amplifier circuit is used in a UWB receiver in a case in which the second switch is turned on, to simulate operation of the low noise amplifier circuit. A simulation result is shown in FIG. 12. (I) in FIG. 12 shows a gain performance curve of the low noise amplifier circuit, and (II) in FIG. 12 shows a noise performance curve of the low noise amplifier circuit. It can be learned from the operation of the low noise amplifier circuit that, for a radio frequency signal with an operating frequency band in a high frequency band (Group 3) of 6.0 GHz to 10.6 GHz, the low noise amplifier circuit provides a maximum gain of 23 dB; and for an interference signal with an operating frequency band in a mid-frequency band (Group 2) of 4.8 GHz to 6.0 GHz, the low noise amplifier circuit provides a minimum gain of -16.5 dB. Overall, for the interference signal with the operating frequency band in the mid-frequency band (Group 2) of 4.8 GHz to 6.0 GHz, the low noise amplifier circuit provides maximum suppression of 39 dB and minimum suppression greater than 20 dB. In addition, a maximum noise figure of the low noise amplifier circuit is 24.6 dB, and a minimum noise figure is 2.4 dB. It can be learned that the low noise amplifier circuit provided in this embodiment of this application can have a good anti-interference capability with low power consumption, and also have a good gain and good noise performance.

It may be understood that, in this embodiment of this application, a capability of the low noise amplifier circuit to suppress interference signals of different frequency bands may be further changed by adjusting the capacitance value of the first capacitor and the inductance value of the first inductor in the notch circuit. For example, if strength of an 802.11a signal in interference signals is the greatest, the oscillation frequency of the notch circuit may be made to be an operating frequency of the 802.11a signal by adjusting the capacitance value of the first capacitor and the inductance value of the first inductor. To be specific, the oscillation frequency of the notch circuit is 5.825 GHz. In this case, a frequency corresponding to a highest point in the noise performance curve shown in (II) in FIG. 12 is 5.825 GHz. In other words, the low noise suppression circuit has a strongest capability of suppressing the 802.11a signal.

In an optional embodiment, oscillation frequencies of the fifth capacitor and the primary coil of the transformer are in the preset operating frequency band.

In this embodiment, the fifth capacitor and the primary coil of the transformer jointly form an LC resonant circuit. A capacitance value of the fifth capacitor is properly set, so that an oscillation frequency of the LC resonant circuit is in the preset operating frequency band. For example, the oscillation frequency of the LC resonant circuit is set to 8 GHz. In this way, a gain of the low noise amplifier circuit can be further increased.

In an optional embodiment, the fifth capacitor is a tunable capacitor.

In this embodiment, the fifth capacitor is set as a tunable capacitor, and the oscillation frequency of the LC resonant circuit is made to be any frequency in the preset operating frequency band by adjusting the capacitance value of the fifth capacitor, to increase a gain of the low noise amplifier circuit. For example, a center frequency of an operating frequency of the low noise amplifier circuit is approximately 8 GHz. In this case, the capacitance value of the fifth capacitor may be adjusted to make the oscillation frequency of the LC resonant circuit be 8 GHz. When the center frequency of the operating frequency of the low noise amplifier circuit is changed to 7.5 GHz, the capacitance value of the fifth capacitor may be adjusted again to change the oscillation frequency of the LC resonant circuit to 7.5 GHz. In this way, the low noise amplifier circuit always keeps a high gain.

In an optional embodiment, the first gating switch includes a control end, the control end of the first gating switch receives a first control word, and the first control word is used to control the common end of the first gating switch to connect to the first gating end of the first gating switch; or the control end of the first gating switch receives a second control word, and the second control word is used to control the common end of the first gating switch to connect to the second gating end of the first gating switch.

In this embodiment, the control end of the first gating switch receives the first control word Gtune1 <4:0>, and the common end of the first gating switch is connected to the first gating end of the first gating switch under the control of the first control word Gtune1<4:0>, so that a part of an output current of the second-stage amplifier circuit flows into the first switch. Alternatively, the control end of the first gating switch receives the second control word Gtune2<4:0>, and the common end of the first gating switch is connected to the second gating end of the first gating switch under the control of the second control word Gtune2<4:0>, so that a part of an output current of the second-stage amplifier circuit flows into the second switch.

It may be understood that, in this embodiment, a proportion of an output current of the second-stage amplifier circuit flowing into the first switch or the second switch may be further adjusted by setting the first control word or the second control word. For example, the second control word is a 5-bit binary signal, and the second control word is set to 11111. In this case, an entire output current of the second-stage amplifier circuit is controlled to flow into the second switch, so that a gain of the low noise amplifier circuit is maximum. Alternatively, the first control word is a 5-bit binary signal, and the first control word is set to 11111. In this case, an entire output current of the second-stage amplifier circuit is controlled to flow into the first switch, so that a gain of the low noise amplifier circuit is minimum. In addition, the first control word or the second control word may alternatively be set to any number in 00001 to 11111, to adjust the gain of the low noise amplifier circuit by adjusting the proportion of the output current of the second-stage amplifier circuit flowing into the first switch or the second switch.

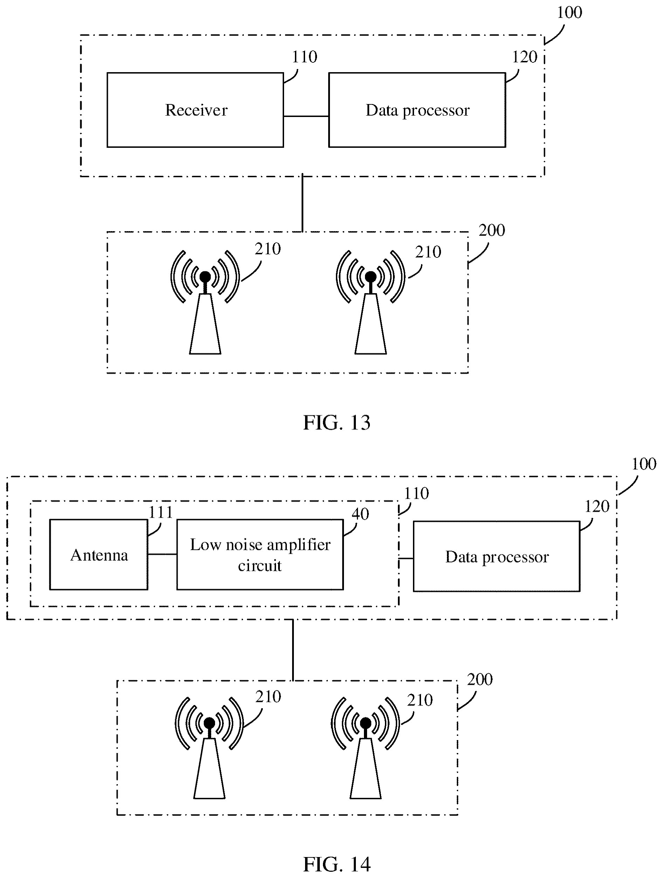

An embodiment of this application further provides a wireless device. FIG. 13 is a diagram of communication between a wireless device 100 and a wireless communication system 200. The wireless communication system 200 may be a long term evolution (LTE) system, a code division multiple access (CDMA) system, a global system for mobile communications (GSM), a wireless local area network (WLAN) system, or another wireless system. The CDMA system may implement wideband CDMA (WCDMA), CDMA 2000, or CDMA of another version. For brevity, FIG. 13 shows that the wireless communication system 200 includes two base stations 210. In general, a wireless system may include any quantity of base stations and any network entity set.

The wireless device 100 may be referred to as user equipment (UE), a mobile station, a terminal, an access terminal, or the like. The wireless device 100 may be a cellular phone, a smartphone, a tablet device, a wireless modem, a personal digital assistant (PDA), a handheld device, a laptop computer, a smartbook, a netbook, a cordless phone, a wireless local loop (WLL) station, a Bluetooth device, or the like. The wireless device 100 may communicate with a plurality of wireless communication systems 200. The wireless device 100 may receive a signal from a broadcast station, a signal from a satellite in one or more global navigation satellite systems (GNSSs), and the like. The wireless device 100 may support one or more radio technologies used for wireless communication, such as LTE, CDMA 2000, WCDMA, GSM, 802.11, and the like.

The wireless device 100 includes a receiver 110 and a data processor 120. The data processor 120 is configured to process a radio frequency signal output by the receiver 110. Refer to FIG. 14. In an optional embodiment, the receiver 110 in the wireless device includes an antenna 111 and a low noise amplifier circuit 40. The low noise amplifier circuit 40 is configured to amplify a radio frequency signal received by the antenna 111.

In this embodiment, the receiver is provided with the antenna and the low noise amplifier circuit. A base station and/or another transmitter station in the wireless communication system transmit/transmits signals of various frequency bands, and the signals of various frequency bands are provided to the receiver of a router in the base station and/or the another transmitter through a switch/duplexer. At the receiver, the antenna of the receiver selects an operating signal of a required frequency band and transfers the operating signal to the low noise amplifier circuit. The operating signal includes a radio frequency signal and an interference signal. For example, when the receiver is a UWB receiver, the antenna provides, to the low noise amplifier circuit, a radio frequency signal with an operating frequency band of 3.1 GHz to 4.8 GHz and/or a radio frequency signal with an operating frequency band of 6.0 GHz to 10.6 GHz, and an interference signal with an operating frequency band of 4.8 GHz to 6.0 GHz. The low noise amplifier circuit amplifies the radio frequency signal and suppresses impact of the interference signal on the receiver.

It may be understood that, in another optional embodiment, the receiver may further include a controller, and the controller of the receiver may send a first control word or a second control word to the low noise amplifier circuit, to adjust a gain of the low noise amplifier circuit, to improve performance of the receiver. In addition, the controller of the receiver may further send a capacitance adjustment signal to the low noise amplifier circuit, to adjust capacitance values of a plurality of capacitors in the low noise amplifier circuit. For example, the controller sends a first capacitance adjustment signal to the low noise amplifier circuit, and the low noise amplifier circuit adjusts a capacitance value of a first capacitor in a notch circuit under effect of the first capacitance adjustment signal, to adjust a capability of the low noise amplifier circuit to suppress interference signals of different frequency bands.

It should be noted that the receiver in this embodiment may alternatively be another type of receiver, for example, a Wi-Fi 5G receiver. In addition, the receiver may further include modules of other functions, for example, may further include a frequency mixer, a filter, an oscillator, a local oscillator (LO), a generator, a phase-locked loop (PLL), and the like. The whole or a part of the receiver may be implemented on one or more analog integrated circuits (ICs), radio frequency integrated circuits RFICs, mixed signal ICs, or the like. For example, the antenna may be separately implemented on a module, to facilitate installation outside the receiver. The low noise amplifier circuit, the frequency mixer, and the filter may be implemented on one module, and the module may be an RFIC or the like.

The data processor 120 may perform various functions for the wireless device 100. For example, the data processor 120 may process data output by the receiver 110, to obtain required data information through demodulation. The data processor 120 may further include a memory 121, and the memory may store program code and data for use by the data processor 120. The data processor 120 may be implemented on one or more application-specific integrated circuits (ASICs) and/or other ICs.

A specific process of communication between the wireless device and the wireless communication system provided in this embodiment is as follows: A base station in the wireless communication system converts data information into a radio frequency signal and transmits the radio frequency signal, and the radio frequency signal is provided to a receiver of a router in the base station through a switch/duplexer. The receiver receives an operating signal of a required frequency band. The operating signal includes a radio frequency signal and an interference signal. For example, when the receiver is a UWB receiver, the receiver receives a radio frequency signal with an operating frequency band of 3.1 GHz to 4.8 GHz and/or a radio frequency signal with an operating frequency band of 6.0 GHz to 10.6 GHz, and an interference signal with an operating frequency band of 4.8 GHz to 6.0 GHz. The receiver amplifies the radio frequency signal in the operating signal and processes an amplified radio frequency signal, for example, converts the amplified radio frequency signal into a low-frequency signal, a mid-frequency signal, or a baseband signal. In addition, the receiver suppresses impact of the interference signal on the receiver. The data processor demodulates a processed signal output by the receiver, to restore the data information sent by the base station.

It may be understood that, all or some of the foregoing embodiments may be implemented by using software, hardware, firmware, or any combination thereof. When software is used to implement embodiments, all or some of the embodiments may be implemented in a form of computer program product.

The computer program product includes one or more computer instructions. When the computer program instructions are loaded and executed on a computer, all or some of the procedures or functions according to embodiments of the present invention are generated. The computer may be a general-purpose computer, a dedicated computer, a computer network, or another programmable apparatus. The computer instructions may be stored in a computer-readable storage medium or may be transmitted from a computer-readable storage medium to another computer-readable storage medium. For example, the computer instructions may be transmitted from a website, computer, server, or data center to another website, computer, server, or data center in a wired (for example, a coaxial cable, an optical fiber, or a digital subscriber line (DSL)) or wireless (for example, infrared, radio, or microwave) manner. The computer-readable storage medium may be any usable medium that can be stored by a computer, or a data storage device, such as a server or a data center, integrating one or more usable media. The usable medium may be a magnetic medium (for example, a floppy disk, a hard disk drive, or a magnetic tape), an optical medium (for example, a DVD), a semiconductor medium (for example, a solid-state disk (Solid-State Disk, SSD)), or the like.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A low noise amplifier circuit, comprising a first-stage amplifier circuit, a second-stage amplifier circuit, and a notch circuit, wherein
an input of the first-stage amplifier circuit is configured to receive an operating signal, an output of the first-stage amplifier circuit is separately connected to an input of the second-stage amplifier circuit and a first end of the notch circuit, the operating signal comprises a radio frequency signal with a first frequency and an interference signal with a second frequency, the first frequency is in a preset operating frequency band, and the second frequency is in an operating frequency band other than the preset operating frequency band;
an output of the second-stage amplifier circuit is connected to a second end of the notch circuit; and
an impedance value between the first end of the notch circuit and the second end of the notch circuit in the preset operating frequency band is a first impedance value, an impedance value between the first end of the notch circuit and the second end of the notch circuit in the operating frequency band other than the preset operating frequency band is a second impedance value, the first impedance value is greater than a first threshold, and the second impedance value is less than the first threshold.

2. The circuit according to claim 1, wherein the notch circuit comprises a first capacitor and a first inductor; and a first end of the first capacitor is connected to the second end of the notch circuit, a second end of the first capacitor is connected to a first end of the first inductor, and a second end of the first inductor is connected to the first end of the notch circuit.

3. The circuit according to claim 2, wherein an oscillation frequency of the notch circuit is in the operating frequency band other than the preset operating frequency band.

4. The circuit according to claim 2, wherein the first capacitor is a tunable capacitor, and the first inductor is a tunable inductor.

5. The circuit according to claim 1, wherein the first-stage amplifier circuit comprises a second inductor, a third inductor, a second capacitor, a first resistor, and a first amplifier;
a first end of the second inductor is connected to the input of the first-stage amplifier circuit, and a second end of the second inductor is connected to a first end of the second capacitor;
a first end of the first resistor receives a first turn-on voltage, and a second end of the first resistor is connected to a second end of the second capacitor; and
a control end of the first amplifier is connected to the second end of the second capacitor, a first end of the first amplifier is connected to the output of the first-stage amplifier circuit, a second end of the first amplifier is connected to a first end of the third inductor, and a second end of the third inductor is grounded.

6. The circuit according to claim 1, wherein the second-stage amplifier circuit comprises a second resistor, a third capacitor, a fourth capacitor, a fourth inductor, and a second amplifier;
a first end of the second resistor receives a second turn-on voltage, and a second end of the second resistor is connected to a control end of the second amplifier;
the control end of the second amplifier is connected to a first end of the third capacitor, a first end of the second amplifier is connected to the output of the second-stage amplifier circuit, a second end of the second amplifier is separately connected to a first end of the fourth capacitor and a first end of the fourth inductor, and a second end of the fourth capacitor is grounded; and
a second end of the fourth inductor is separately connected to a second end of the third capacitor and the input of the second-stage amplifier circuit.

7. The circuit according to any one of claims 1 to 6, wherein the low noise amplifier circuit further comprises a load circuit, and an input of the load circuit is connected to the output of the second-stage amplifier circuit.

8. The circuit according to claim 7, wherein the load circuit comprises a first gating switch, a first switch, a second switch, a fifth capacitor, and a transformer;
a common end of the first gating switch receives a third turn-on voltage, a first gating end of the first gating switch is connected to a control end of the first switch, and a second gating end of the first gating switch is connected to a control end of the second switch;
a first end of the first switch is connected to a first power supply, and a second end of the first switch is connected to a first end of the load circuit;
a first end of the second switch is connected to a second end of the fifth capacitor, and a second end of the second switch is connected to the first end of the load circuit; and
a first end of the fifth capacitor is separately connected to the first power supply and a first end of a primary coil of the transformer, and the second end of the fifth capacitor is connected to a second end of the primary coil of the transformer.

9. The circuit according to claim 8, wherein oscillation frequencies of the fifth capacitor and the primary coil of the transformer are in the preset operating frequency band.

10. The circuit according to claim 8, wherein the fifth capacitor is a tunable capacitor.

11. The circuit according to any one of claims 8 to 10, wherein the first gating switch comprises a control end; and the control end of the first gating switch receives a first control word, and the first control word is used to control the common end of the first gating switch to connect to the first gating end of the first gating switch; or
the control end of the first gating switch receives a second control word, and the second control word is used to control the common end of the first gating switch to connect to the second gating end of the first gating switch.

12. A receiver, comprising an antenna and the low noise amplifier circuit according to any one of claims 1 to 11, wherein the low noise amplifier circuit is configured to amplify a radio frequency signal received by the antenna.

13. A wireless device, comprising a data processor and the receiver according to claim 12, wherein the data processor is configured to process a radio frequency signal output by the receiver.
